# DEMANDE DE BREVET EUROPEEN

(11) **EP 4 715 076 A1**
(43) Date de publication de la demande: **25.03.2026**
(21) Numéro de dépôt: 24200981.9
(22) Date de dépôt: 18.09.2024
(51) Int. Cl.: C22C 18/00, A44C 27/00, C22C 19/03, C22C 21/00, C22C 21/10, C30B 21/00, C30B 29/52, C30B 29/62, C22C 18/04, C30B 33/10

(54) **PROCÉDÉ DE FABRICATION D'UNE PIÈCE PRÉSENTANT UNE SURFACE NOIR PROFOND**

(71) Demandeur: The Swatch Group Research and Development Ltd, 2074 Marin (CH)
(72) Inventeur: CLERC, Steve, 2000 Neuchâtel (CH); BOURBAN, Stewes, 1589 Chabrey (CH)
(74) Mandataire: ICB SA

(57) **Abrégé**

Un aspect de l'invention concerne un procédé de fabrication d'une structure noire d'un matériau (10) comprenant au moins deux phases dont au moins une phase cristalline (1), et au moins une autre phase, dite matrice (2), le procédé étant caractérisé ce qu'il comprend les étapes suivantes :
- faire croître le matériau selon une direction principale (Z) de manière que l'au moins une phase cristalline forme plusieurs tiges alignées entre elles et que la matrice s'étende entre les tiges,
- éliminer au moins en partie la matrice située entre les tiges de l'au moins une phase cristalline,
- de manière à former une structure de matériau du type peigne présentant des tiges et des cavités de piège de lumière entre lesdites tiges.

## Description

### Domaine technique de l'invention

La présente invention concerne un procédé de fabrication d'une pièce ayant pour but de réaliser une surface de couleur noir profond/intense/soutenu.

La pièce, par exemple du type métal, céramique, polymère, comprend au moins deux phases : au moins une phase cristalline et une autre phase dite matrice, la pièce étant obtenue selon les étapes suivantes :
- une méthode de croissance dirigée et/ou orientée selon une direction principale des au moins deux phases de manière que l'au moins une phase cristalline formant plusieurs tiges s'érigeant ou faisant saillie, en particulier depuis un support, lesdites tiges étant sensiblement alignées entre elles, l'autre phase dite matrice s'étendant entre lesdites tiges ;
- une étape d'élimination au moins partielle de la matrice située entre les tiges, de manière à former une structure de type peigne ou forêt de tiges ou multitude de tiges.

### Arrière-plan technologique

Afin d'obtenir des surfaces noires intenses, il est connu une méthode comprenant une première étape de nettoyage d'une surface d'aluminium puis une seconde étape de croissance de nanotube de carbone. En particulier la méthode correspond à la dépose par CVD (dépôt chimique en phase vapeur) de nanotubes de carbone ou filaments microscopiques de carbone selon une direction verticale de manière à réaliser une "forêt" de nanotubes de carbone. En particulier la croissance des nanotubes est réalisée sur une surface d'une feuille d'aluminium gravée au chlore en particulier au chlorure de sodium NaCl. Cette disposition permet d'absorber la lumière.

### Résumé de l'invention

A cet effet, et selon un premier aspect, l'invention propose un procédé de fabrication d'une pièce ou structure noire d'un matériau comprenant au moins deux phases dont au moins une phase cristalline et au moins une autre phase, dite matrice, le procédé comprenant les étapes suivantes :
- faire croître le matériau selon une direction principale de manière que l'au moins une phase cristalline forme plusieurs tiges alignées entre elles et que la matrice s'étende entre lesdites tiges,
- éliminer au moins en partie la matrice située entre lesdites tiges de l'au moins une phase cristalline,
- de manière à former une structure de matériau de type peigne présentant des tiges et des cavités de piège de lumière entre lesdites tiges, de manière à absorber la lumière.

Pour ce qui précède et pour la suite de la description, on entend par support, un matériau qui peut être ou non le matériau destiné à être dirigé et/ou faire croître, et/ou un matériau présentant des propriétés thermiques et chimiques autorisant la solidification dirigée, le matériau du support peut être différent selon le type de matériau dirigé, le support peut présenter différentes géométries, par exemple une face plane ou en trois dimensions. Le support pourra être appelé aussi face de départ.

De préférence, les étapes ci-dessus du procédé sont réalisées dans cet ordre.

Selon différents modes ou variantes de réalisations pouvant, ou non, être combinables entre eux, le procédé de fabrication comprend ou présente les caractéristiques ou étapes suivantes :
- le matériau peut être du type métal, ou du type céramique, ou du type polymère ou une combinaison de ceux-ci ;
- le matériau peut être un alliage, de préférence à base d'aluminium et/ou de nickel et/ou de zinc, par exemple un alliage eutectique ;
- le matériau peut comprendre du carbone ou du graphite ;
- l'au moins une phase cristalline peut comprendre plusieurs phases cristallines ;
- la matrice peut être ou comprendre une ou plusieurs phases cristallines et/ou une ou plusieurs phases amorphes dite de matrice ;
- l'étape de croissance correspond à faire ériger ou faire saillir le matériau considéré selon une direction principale, de manière à diriger les tiges selon ladite direction principale, plus ou moins 20 degrés, de préférence plus ou moins 10 degrés, de préférence plus ou moins 5 degrés ;
- l'étape de croissance peut être réalisée depuis un support, dit aussi face de départ ;
- l'étape de croissance peut être réalisée selon une direction principale sensiblement perpendiculaire par rapport à la face de départ ou du support, dit autrement présentant un angle de 90 degrés par rapport à la face de départ, de préférence la direction de croissance présente un angle compris entre 70 et 110 degrés ;
- l'étape de croissance est réalisée par solidification directionnelle, de préférence thermique ou par chauffage ou refroidissement, notamment la solidification directionnelle peut être contrôlée par la vitesse de refroidissement ; par exemple la solidification directionnelle peut être contrôlée en sortie d'un four, en contrôlant par exemple la vitesse de sortie du four et donc le refroidissement ;
- de préférence, on entend par tige de l'au moins une phase cristalline, filament, tube, lamelle, cylindre, dendrite, ou tout élément agencé et configurable pour s'étendre selon une direction principale longitudinale et s'étendant dans une moindre mesure selon une direction transversale, par exemple présentant des protubérances transversales ;
- la face de départ est de préférence une phase solide agencée et configurée pour permettre la croissance dirigée, en particulier selon une direction perpendiculaire ;
- par exemple, l'espace entre les tiges peut présenter une dimension supérieure au diamètre des tiges, le diamètre de tige peut être au moins de 100 nanomètres, la hauteur de tige peut être au moins de 10 micromètres ;
- l'étape de croissance peut, selon certains modes de réalisation, fournir environ 5 à 20% de tiges s'étendant selon une autre direction que la direction principale, par exemple formant un angle supérieur à 20 degrés par rapport à la direction principale, de préférence formant un angle supérieur à 30 degrés par rapport à la direction principale, de préférence formant un angle supérieur à 40 degrés par rapport à la direction principale, de préférence formant un angle supérieur à 50 degrés par rapport à la direction principale ;
- l'étape d'élimination au moins en partie de la matrice est réalisée sans éliminer lesdites tiges ou l'au moins une phase cristalline ; néanmoins il est possible que l'étape d'élimination élimine un pourcentage des tiges de l'au moins une phase cristalline, en particulier inférieur à 10% de préférence inférieur à 5% ;
- l'étape d'élimination au moins en partie de la matrice est une étape d'élimination sélective agencée et configurée pour agir en priorité sur la matrice ;
- l'étape d'élimination peut être réalisée de manière chimique ou électrochimique, thermique ou physique, ou une combinaison de plusieurs de ces méthodes ;
- l'étape d'élimination peut être agencée et configurée pour limiter ou éliminer ou dissoudre au moins en partie des protubérances s'étendant transversalement à la direction principale de croissance ;
- de préférence, l'espace entre les tiges, correspondant à l'au moins autre phase, étant le lieu d'un traitement de surface ou du volume ou du milieu de manière à dissoudre ou éliminer ou limiter au moins une partie de l'autre phase ;
- l'étape d'élimination peut être réalisée par une solution comprenant du NaOH ou HNO3, de préférence dans un bain de ladite solution ;
- de préférence, le procédé de fabrication peut comprendre en outre une étape de découpe selon une direction transversale, ou perpendiculaire, ou orthogonale, plus ou moins quelques degrés angulaires, à la direction d'extension des tiges, en particulier selon la direction principale, de préférence entre l'étape de croissance et l'étape d'élimination ;
- de préférence, le procédé de fabrication peut comprendre en outre une étape de polissage, et/ou sablage.

Selon un mode de réalisation, le matériau comprend des nanotubes de carbone.

Selon un autre mode de réalisation, le matériau exclut des nanotubes de carbone.

Selon un autre aspect, l'invention propose une pièce d'habillage horloger susceptible d'être obtenue à partir de ce procédé

Selon un autre aspect, l'invention propose une pièce noire, notamment une pièce d'habillage horloger, présentant un matériau comprenant au moins deux phases dont au moins une phase cristalline et au moins une autre phase, dite matrice, la pièce étant obtenue par une ou plusieurs des caractéristiques ou étapes du procédé de fabrication du premier aspect.

Par exemple, il est obtenu une structuration métallurgique présentant un matériau biphasé.

### Brève description des figures

D'autres caractéristiques et avantages de l'invention ressortiront de la description détaillée de l'invention qui va suivre en référence aux figures annexées et dans lesquelles :
- la figure 1 montre trois représentations schématiques correspondant à trois modes de réalisation d'un matériau érigé depuis une face de départ, chaque représentation présentant des tiges alignées entre elles selon une direction principale d'au moins une phase cristalline et au moins une autre phase disposée entre les tiges, chaque représentation présentant une vue schématique de dessus et une vue schématique de côté ;
- la figure 2 est une vue de côté d'un matériau présentant des tiges alignées entre elles selon une direction principale d'au moins une phase cristalline et au moins une autre phase, dite matrice, disposée entre les tiges, au moins une partie de la matrice étant éliminée entre les tiges selon un mode de réalisation ;
- la figure 3 est une image au microscope électronique d'un matériau, vu de côté, présentant des tiges alignées entre elles selon une direction principale d'au moins une phase cristalline selon un mode de réalisation, et
- la figure 4 est une image au microscope électronique d'un matériau, vu de dessus, conforme à la figure précédente.

Pour plus de clarté, les éléments identiques ou similaires des différents modes de réalisation sont repérés par des signes de référence identiques sur l'ensemble des figures.

### Description détaillée de l'invention

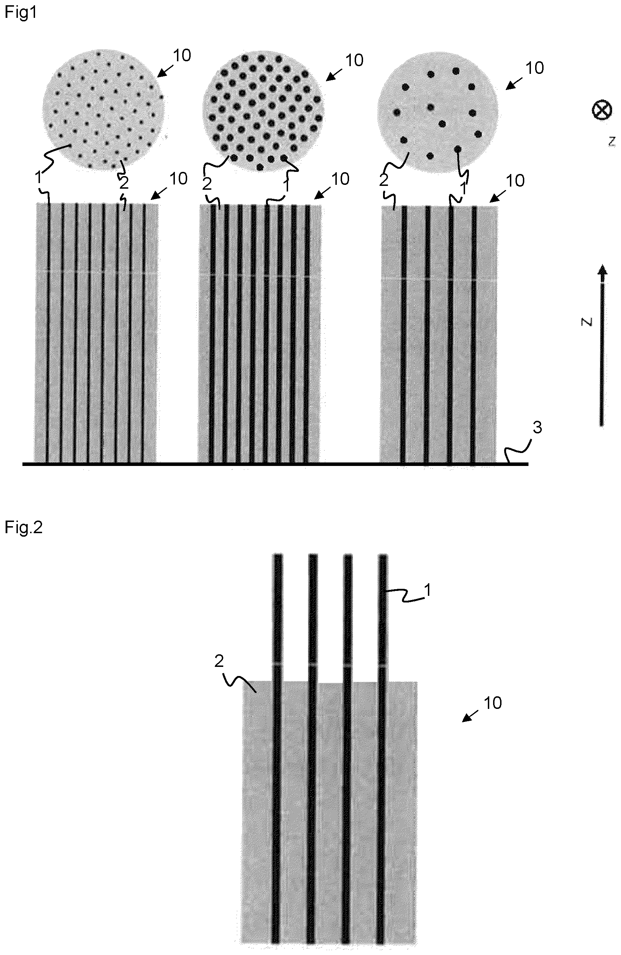

En relation avec les figures 1 et 2, il est décrit un procédé de fabrication d'une pièce, notamment une pièce d'habillage horloger, ou d'une structure noire d'un matériau 10 comprenant deux phases : une phase cristalline 1, et une autre phase, dite matrice 2.

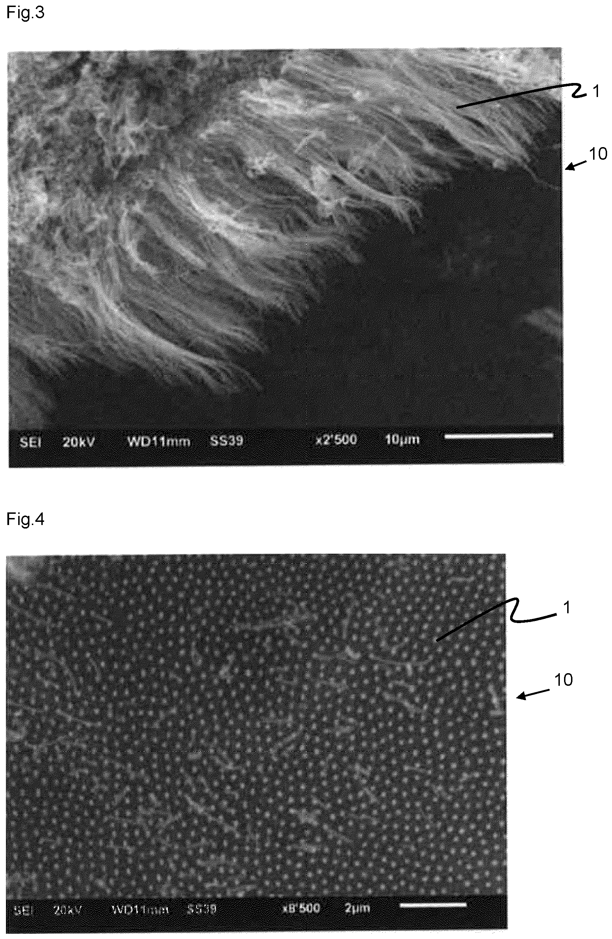

Le procédé comprend les étapes suivantes dans cet ordre :
- en référence aux figures 1 et 3, faire croître selon un procédé de solidification directionnelle le matériau selon une direction principale Z depuis une face de départ 3 de manière que la phase cristalline 1 forme plusieurs tiges alignées entre elles et la matrice 2 s'étende entre les tiges,
- en référence à la figure 2, éliminer au moins en partie la matrice située entre les tiges de la phase cristalline, selon une profondeur de quelques centaines de nanomètres à quelques dizaines de micromètres,
- de manière à former une structure de matériau du type peigne présentant des tiges et des cavités de piège de lumière entre lesdites tiges de manière à absorber la lumière permettant d'obtenir un rendu noir.

La figure 1 montre en particulier trois représentations, vues de côté et vues de dessus, illustrant des exemples de différents cylindres de taille de phase, de fraction de phase et d'espacement de phase.

La phase cristalline 1 se présente sous la forme de fins filaments ou de fines dendrites alignés selon une direction ou un axe Z.

Par exemple, la phase cristalline représente entre 3% et 50% en volume du matériau. L'autre phase dite matrice 2 entoure les filaments et représente le restant de l'alliage, en particulier entre 50% et 97% en volume de matériau.

La face de départ 3 peut être n'importe quel matériau à condition d'autoriser une croissance dirigée.

Dans la sélection des éléments chimiques du matériau, un critère important est l'attaque qui dissoudra ou éliminera au moins en partie la matrice et laissera exposés les filaments ou les fines dendrites de la phase cristalline le long d'une certaine profondeur, par exemple de quelques centaines de nanomètres, à quelques centaines de microns selon la taille et l'espacement des filaments ou fines dendrites.

De préférence, l'étape d'élimination est réalisée de manière chimique. La solution d'attaque doit être déterminée selon la chimie de l'alliage et des phases en présence, afin de dissoudre la matrice sans trop attaquer les filaments ou fines dendrites. Il faut donc que la matrice puisse être attaquée par un produit qui n'attaque pas (ou très peu) l'autre phase.

Par exemple, l'étape d'élimination est réalisée de manière chimique par une solution comprenant du NaOH ou HNO3, par exemple en utilisant un bain de ladite solution.

Selon un exemple, présentant comme matériau un alliage eutectique Al-Ni avec 3.1%at de nickel, il est obtenu une phase cristalline AI3Ni, d'environ 12%, dans une matrice de solution solide d'aluminium, d'environ 88%. La solution solide d'aluminium peut être dissoute dans une solution comprenant du NaOH, qui n'attaquera pas (ou très peu) la phase Al3Ni. La solution peut agir plusieurs minutes ou plusieurs heures.

Selon un autre exemple, il peut être prévu une attaque de l'alliage AIZn (59%at de Zn) dans une solution de HNO3 pour dissoudre la solution solide de zinc et exposer les dendrites de solution solide d'aluminium. La solution peut être plus ou moins diluée, et la durée peut varier par exemple entre plusieurs minutes ou plusieurs heures.

En référence aux figures 3 et 4, le procédé de fabrication peut prévoir en outre une étape de découpe selon une direction transversale à la direction d'extension des tiges, en particulier selon une direction perpendiculaire à l'axe Z ou sensiblement perpendiculaire à cet axe Z.

L'étape de croissance vise à faire croître de manière rectiligne des tiges de la phase cristalline. L'étape de découpe permet notamment de couper, selon un plan sensiblement perpendiculaire à la direction principale, les extrémités des tiges, AI3Ni selon un exemple ci-dessus, de manière à obtenir des extrémités de tiges sensiblement perpendiculaire au plan de coupe, voir figure 4, et donc à la surface de la pièce que l'on cherche à noircir.

De préférence, l'étape de découpe est réalisée après l'étape de croissance et avant l'étape d'élimination.

La surface perpendiculaire ainsi créée correspond à la surface noire après attaque.

De manière optionnelle, il peut être prévu une étape de polissage et/ou sablage de la surface de la pièce afin d'améliorer le rendu aléatoire de la surface.

L'invention est décrite dans ce qui précède à titre d'exemple. Il est entendu que l'homme du métier est à même de réaliser différentes variantes de réalisation de l'invention sans pour autant sortir du cadre de l'invention.

## Revendications

1. Procédé de fabrication d'une structure noire d'un matériau (10) comprenant au moins deux phases dont au moins une phase cristalline (1), et au moins une autre phase, dite matrice (2), le procédé étant **caractérisé en ce qu'**il comprend les étapes suivantes :
- faire croître le matériau selon une direction principale (Z) de manière que l'au moins une phase cristalline forme plusieurs tiges alignées entre elles et que la matrice s'étende entre les tiges,
- éliminer au moins en partie la matrice située entre les tiges de l'au moins une phase cristalline,
- de manière à former une structure de matériau du type peigne présentant des tiges et des cavités de piège de lumière entre lesdites tiges.

2. Procédé selon la revendication 1, dans lequel le matériau est du type métal, ou céramique ou polymère, ou une combinaison de ceux-ci.

3. Procédé selon la revendication 1, dans lequel le matériau est un alliage, de préférence à base d'aluminium et/ou de nickel et/ou de zinc.

4. Procédé selon l'une des revendications précédentes, dans lequel l'étape de croissance est réalisée par solidification directionnelle.

5. Procédé selon l'une des revendications précédentes, dans lequel l'étape d'élimination est réalisée de manière chimique ou électrochimique, thermique ou physique.

6. Procédé selon l'une des revendications précédentes, dans lequel l'étape d'élimination est réalisée par une solution comprenant du NaOH ou HNO3, de préférence dans un bain de ladite solution.

7. Procédé selon l'une des revendications précédentes, comprenant en outre une étape de découpe selon une direction transversale à la direction d'extension des tiges, de préférence entre l'étape de croissance et l'étape d'élimination.

8. Procédé selon l'une des revendications précédentes, comprenant en outre une étape de polissage, et/ou sablage.

9. Pièce d'habillage horloger susceptible d'être obtenue à partir du procédé selon l'une quelconque des revendications précédentes.
